# FASCICULE DE BREVET EUROPEEN

(11) **EP 4 330 644 B1**
(45) Date de publication et mention de la délivrance du brevet: **22.07.2026**
(21) Numéro de dépôt: 22726485.0
(22) Date de dépôt: 28.04.2022
(51) Int. Cl.: G01N 27/92, G01R 31/12, G01R 31/52, G01R 31/08, G01R 31/11

(54) **PROCÉDÉ DE CONTRÔLE DISCRIMINANT D'UN ASSEMBLAGE COMPOSITE MULTI-MATÉRIAUX**
VERFAHREN ZUR DISKRIMINANTEN ÜBERWACHUNG EINER VERBUNDANORDNUNG AUS MEHREREN MATERIALIEN
METHOD FOR DISCRIMINANT MONITORING OF A COMPOSITE MULTI-MATERIAL ASSEMBLY

(30) Priorité: 29.04.2021 FR 2104512
(43) Date de publication de la demande: 06.03.2024
(73) Titulaire: Epsilon Composite, 33340 Gaillan-en-Médoc (FR)
(72) Inventeur: FERRER, Denis, 33180 VERTHEUIL (FR)
(74) Mandataire: Novagraaf Technologies
(86) Numéro de dépôt international: PCT/FR2022/050810
(87) Numéro de publication internationale: WO 2022/229562

(56) Documents cités:
- EP-A1- 1 928 001
- CN-A- 112 557 847
- CN-A- 112 578 247
- CN-A- 112 611 942
- FR-A1- 2 716 720
- FR-A1- 2 982 372
- JP-A- 2013 026 171
- US-A1- 2009 289 642

## Description

### Domaine technique de l'invention

La présente invention relève du domaine des assemblages composites multi-matériaux comportant deux couches jointes, dont l'une interne est en matériau conducteur de l'électricité et dont l'autre externe est en matériau électriquement isolant.

En particulier, la présente invention relève du domaine des infrastructures de génie civil liées au transport d'énergie, et plus spécifiquement du domaine des câbles électriques aériens dont on cherche à réaliser un contrôle discriminant en vue de détecter, voire de localiser, un défaut dans la couche externe en matériau isolant et/ou dans la couche interne se propageant sous contrainte de stockage à travers la couche externe.

Par composite, on entend, au sens de la présente invention, un matériau comprenant des fibres de renfort de grandes longueurs et une matrice imprégnant les fibres de renfort pour constituer les différentes couches du composite.

Par assemblage composite multi-matériaux, on entend, au sens de la présente invention, un composite constitué de deux types de fibre de renfort, notamment des fibres de carbone (formant la couche interne) et des fibres de verre (formant la couche externe ou deuxième couche) imprégnées dans une même résine garantissant une interface cohésive entre les deux couches.

### Arrière-plan technique

Le besoin de câbles pour le transport et la distribution électrique augmente avec la demande de plus en plus forte d'électricité. Afin de répondre à ce besoin d'augmenter, mais aussi d'améliorer la capacité des câbles existants et également d'améliorer leurs performances mécaniques, il existe actuellement des assemblages composites multi-matériaux à âme structurelle composite majoritairement constituée d'un cœur composite à base de fibres de carbone et d'une couche structurelle et isolante en composite à base de fibres de verre (également appelés joncs). Ces assemblages, qui ont été développés par le demandeur sont typiquement obtenus en mettant en œuvre un procédé de fabrication par pultrusion à partir d'un faisceau de fibres de carbone et d'une matrice polymérique imprégnant et liant les fibres de carbone pour obtenir le cœur composite à base de fibres de carbone, tandis que la couche structurelle et isolante est obtenue lors de la même opération de pultrusion à partir d'un faisceau de fibres de verre et de la même matrice polymérique pour imprégner et lier les fibres de verre.

Le mode de fabrication de tels assemblages comporte intrinsèquement des risques forts :
- un défaut lors de la mise en œuvre du procédé de fabrication par pultrusion (fibres non-alignées, bourrage ou casse de fibres, mauvaise imprégnation, fissuration des joncs liée aux contraintes thermiques de cuisson, etc.) peut faire chuter les propriétés mécaniques de l'assemblage, qui en conséquence ne répondent pas aux critères minima de performances mécaniques et thermiques lors des contrôles qualité ;
- les risques de chocs lors de la fabrication et du conditionnement des assemblages représentent également un risque important et difficilement maitrisable avec un impact majeur sur les performances mécaniques résiduelles des joncs composites.
- de plus, une fois enroulés sur des dispositifs de rotation de type touret ou galette, puis conditionnés en vue de leur transport, ces joncs passent ensuite typiquement plusieurs semaines en environnement contraignant, notamment en cas de transport maritime en raison d'une forte humidité et de températures pouvant être extrêmes (soit très élevées, soit très basses), et de conditions de stockage non contrôlées sur le site de destination.

Du fait de la position de la couche structurelle et isolante en composite à base de fibres de verre dans le jonc par rapport au cœur composite à base de fibres de carbone et de sa rigidité inférieure au carbone, la première apparition de fracture sur le produit en flexion se fera théoriquement au niveau de la couche isolante à base de fibres de verre lors des impacts externes générant une perte de performances mécaniques du composite globale. Il est donc important de caractériser l'intégrité mécanique de cette couche de fibre de verre afin d'adresser un bilan rapide sur l'état global de l'assemblage composite.

La contrainte en flexion appliquée lors du stockage et du transport du jonc en matériaux composites joue par ailleurs également un rôle dans la propagation des défauts critiques initiés dans le cœur composite à base de fibres de carbone jusqu'à la couche supérieure en fibres de verre grâce à l'aspect cohésif entre les deux couches, et ainsi peut aussi générer un endommagement de l'assemblage. Il en va de même lors des opérations de montage de lignes à haute tension.

L'ensemble de ces paramètres montre la nécessité de contrôler la qualité de ces assemblages en termes de performances mécaniques, à la fois en production, mais aussi sur leurs sites d'installation.

Parmi les moyens de contrôle non destructifs classiques pour de tels assemblages composites, plusieurs options connues de l'homme du métier ont été envisagées (notamment par ultrasons, tomographie, etc.). Mais aucune n'a permis de répondre aux enjeux d'un assemblage bi-composite, ni aux besoins d'industrialisation et aux fortes cadences propres au procédé de fabrication par pultrusion.

Afin de pallier les inconvénients précités, le Demandeur a mis au point un procédé de contrôle de la qualité d'un assemblage composite multi-matériaux à partir de la mesure de la tension de claquage.

L'utilisation de la mesure de la tension de claquage est connue de l'homme du métier dans le domaine des câbles aériens (1), (2), ainsi que dans l'industrie des éoliennes (3), (4). En particulier, dans le domaine des câbles aériens il est connu d'utiliser la tension de claquage dans des isolateurs pour surveiller l'état de l'isolation (1). Dans l'industrie des éoliennes par exemple, on utilise la tension de claquage comme stratégie de production pour protéger les pâles de la foudre (3). Cependant, en aucun cas il n'est fait mention du contrôle de la qualité mécanique d'un d'assemblage composites bi-matériaux.

Le document FR2982372A1 décrit un système pour contrôler un câble électrique, qui est composé d'un conducteur protégé par une couche isolante. Le système comprend : une électrode en contact avec l'isolant, un dispositif pour appliquer une tension entre le conducteur et l'électrode, un système de mesure pour détecter les décharges partielles entre le conducteur et l'électrode, causées par la tension appliquée. Le système inclut aussi un mécanisme pour déplacer le câble par rapport à l'électrode. Cela permet de détecter les décharges partielles tout au long du câble pendant son mouvement.

### Exposé de l'invention

Par conséquent, le demandeur a mis au point un procédé de contrôle discriminant d'un assemblage composite multi-matériaux comprenant au moins une couche interne en un premier matériau composite conducteur de l'électricité et une deuxième en un deuxième matériau composite électriquement isolant, la deuxième couche recouvrant la première couche interne selon la revendication indépendante 1.

Dans le cadre de la présente invention, l'assemblage composite multi-matériaux est un matériau composite monolithique, fabriqué en une seule étape, dans lequel la deuxième couche (ou couche externe) est cohésive à la couche interne, ces deux couches constituant des couches structurelles dans l'assemblage composite multi-matériaux selon l'invention. Un tel assemblage composite multi-matériaux est dit «cohésif».

Le contrôle discriminant est réalisé en vue de détecter, voire de localiser, un défaut présent dans la deuxième couche (externe) en matériau isolant ou, selon l'invention, un défaut présent dans la couche interne (en matériau conducteur de l'électricité) se propageant sous contrainte de stockage à travers la couche externe.

La génération de courant et la mesure de la tension de claquage peuvent notamment être réalisées, dans le cadre de la présente invention, par un contrôleur d'isolement.

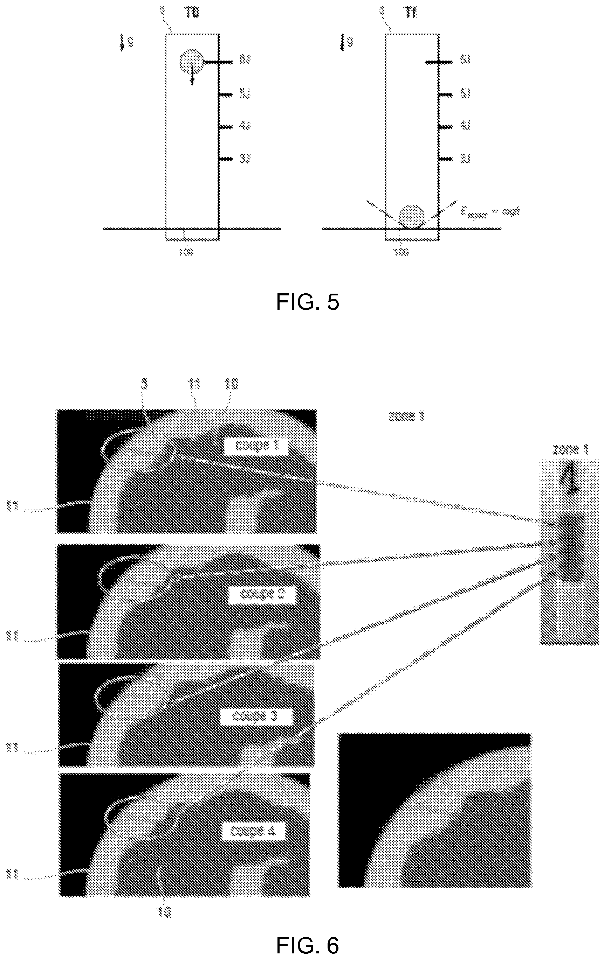

En vue de pouvoir réaliser le contrôle discriminant de l'assemblage composite multi-matériaux et, le cas échéant, de détecter un éventuel défaut structurel et de le caractériser, il convient préalablement de réaliser une calibration. Celle-ci est réalisée pour chaque assemblage de caractéristiques données (épaisseur de la couche isolante, et propriétés diélectriques des matériaux constitutifs de l'assemblage) à l'aide de différents assemblages composites multi-matériaux, dont une partie de ces assemblages est connue pour être sans défaut, tandis qu'une partie comporte une couche en matériau isolant présentant un défaut structurel connu. Sur la base de ces assemblages connus, on réalise une calibration du procédé de contrôle discriminant selon l'invention décrit ci-dessus, en notant la valeur de la tension de claquage (comme illustré à l'exemple 1, ainsi que sur la figure 5) :
- pour chaque assemblage présentant un défaut structurel critique donné, et
- pour chaque assemblage composite sain, c'est-à-dire sans défaut structurel.

Lors du procédé de contrôle discriminant, la mesure d'une tension de claquage permet, grâce à la calibration préalable d'identifier le défaut structurel critique de l'assemblage composite testé soit uniquement dans la deuxième couche (ou couche extérieure), soit dans les deux couches (par exemple des fissures, des chocs, une porosité élevée ou des défauts liés au procédé de fabrication).

A titre de fibres utilisables dans le premier matériau composite électriquement conducteur, on peut notamment citer les fibres métalliques ou les fibres de carbone, se présentant notamment sous forme de fibres longues structurelles. On utilisera de préférence, dans le cadre de la présente invention, des fibres de carbone.

A titre de fibres utilisables dans le deuxième matériau composite électriquement isolant, on peut notamment citer les fibres de verre, de basalte, de bore, de silice, ou les fibres thermoplastiques, se présentant notamment sous forme de fibres longues structurelles. On utilisera de préférence, dans le cadre de la présente invention, des fibres de verre.

Selon un premier mode de réalisation avantageux du procédé selon l'invention, celui-ci pourra notamment s'appliquer plus particulièrement à un assemblage composite multi-matériaux comprenant un élément de renforcement composite de forme tubulaire (ou jonc) destiné à être utilisé dans un câble électrique aérien, cet assemblage étant obtenu par des étapes de superposition et cuisson simultanées de la couche interne et de la deuxième couche, la couche interne étant obtenue par pultrusion à partir d'un faisceau de fibres de carbone et d'une matrice polymérique imprégnant les fibres de carbone et les liant entre elles, et la deuxième couche étant obtenue lors de la même opération de pultrusion à partir d'un faisceau de fibres de verre et de ladite matrice polymérique imprégnant les fibres de verre et les liant entre elles. L'ensemble est cuit ou partiellement cuit en simultané pour assurer la continuité cohésive entre les deux couches structurelles (couche interne et deuxième couche), facilitant la circulation des défauts structurels générés dans l'une des deux couches vers l'autres couche.

Les termes *«étapes de superposition et de cuisson instantanées»* signifient également, par extension, « quasi-instantanées », c'est-à-dire légèrement décalées dans le temps de quelques s, et préférentiellement décalées d'une durée strictement inférieure à 30 s.

L'utilisation d'une matrice polymérique de même nature dans la couche interne (imprégnant les fibres de carbone) et dans la deuxième couche (imprégnant les fibres de verre) favorise la propagation des défauts critiques à travers toutes les couches de l'assemblage grâce à une jonction cohésive entre les deux couches structurelles (couche interne et deuxième couche).

En outre, le fait que l'on polymérise lors de la même étape de cuisson la matrice polymérique imprégnant les fibres de carbone et celle (de même nature) imprégnant les fibres de verre favorise d'autant plus la propagation des défauts critiques à travers toutes les couches de l'assemblage, cette liaison intime entre les couches constituant de fait un élément essentiel à la bonne caractérisation mécanique décrite dans la présente invention

Le premier mode de réalisation du procédé selon l'invention permet d'identifier un défaut dans le jonc dans le cas où l'intégrité de la deuxième couche en matériau isolant est compromise (défaut ou endommagement) : cela peut être réalisé directement sur le jonc en sortie de production (selon une première variante de réalisation) ou sur site, notamment lorsque le jonc est déroulé (selon une deuxième variante de réalisation), comme détaillé ci-après.

Ainsi, selon une première variante de réalisation de ce premier mode de réalisation avantageux, l'étape de contrôle discriminant de l'assemblage composite multi-matériaux peut être réalisée sur la ligne de production de l'élément de renforcement composite de forme tubulaire après les étapes de superposition et de cuisson de la couche interne et de la deuxième couche de l'élément de renforcement composite de forme tubulaire et préalablement à une étape d'enroulement sur un dispositif de mise en rotation (tel qu'un touret) de l'élément de renforcement composite de forme tubulaire ainsi obtenu, le procédé comprenant les étapes suivantes :
- préparation de l'une des extrémités de l'élément de renforcement composite de forme tubulaire par arrimage au dispositif de mise en rotation, puis par mise à nu de la couche interne au niveau de l'extrémité arrimée au dispositif de mise en rotation, l'extrémité constituant la première électrode qui est mise à la terre ;
- application d'une deuxième électrode à la surface de la deuxième couche ;
- mise en rotation du dispositif de mise en rotation, pour enrouler l'élément de renforcement composite de forme tubulaire ;
- contrôle discriminant par génération d'un courant entre les première et deuxième électrodes en appliquant la tension seuil U_{S}.

Selon une deuxième variante de réalisation de ce premier mode de réalisation avantageux,
l'étape de contrôle discriminant peut être réalisée lors du déroulement de l'élément de renforcement composite de forme tubulaire enroulé sur le dispositif de mise en rotation. Dans ce cas, le procédé pourrait se dérouler comme suit par :
- préparation de l'une des extrémités de l'élément de renforcement composite de forme tubulaire enroulé sur le dispositif de mise en rotation par mise à nu de la couche interne au niveau de l'extrémité, qui constitue la première électrode qui est mise à la terre ;
- application d'une deuxième électrode à la surface de la deuxième couche ;
- déroulement de l'élément de renforcement composite de forme tubulaire ;
- contrôle discriminant par génération d'un courant entre les première et deuxième électrodes en appliquant la tension seuil U_{S}.

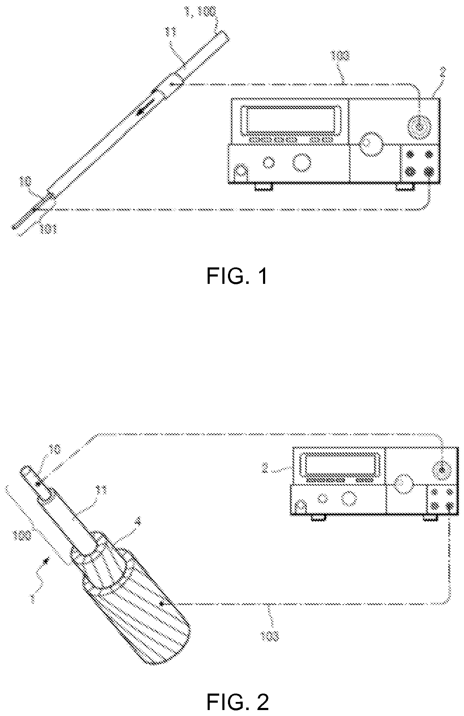

Selon un deuxième mode de réalisation avantageux du procédé selon l'invention, celui-ci pourra notamment s'appliquer plus particulièrement à un assemblage composite multi-matériaux comprenant, outre le jonc (c'est-à-dire l'élément de renforcement composite de forme tubulaire), au moins une couche externe recouvrant au moins partiellement la deuxième couche de l'assemblage composite (ou jonc), cette couche externe étant en matériau conducteur de l'électricité, et de préférence métallique, et mieux en aluminium toronné. Le jonc est enroulé sur touret en cours de production et peut atteindre des longueurs de l'ordre de 4000 m. Il est ensuite recouvert d'une couche de matériau conducteur de l'électricité et notamment métallique (par exemple en aluminium) pour constituer un câble aérien de ligne de transmission électrique haute tension à âme composite (notamment illustré sur la figure 2).

La deuxième couche du jonc à base de fibres de verre constitue un isolant entre la couche externe (typiquement en aluminium) et la couche interne du jonc à base de fibres de carbone, empêchant ainsi toute forme de corrosion galvanique de l'un par l'autre. Le deuxième mode de réalisation du procédé selon l'invention utilise justement le caractère isolant afin de caractériser un défaut de l'assemblage composite multi-matériaux, qui serait indicateur de la santé du câble.

De préférence, dans un tel assemblage composite multi-matériaux, cette couche externe pourra être constituée d'une pluralité de brins conducteurs en aluminium de forme trapézoïdale qui sont enroulés hélicoïdalement autour du jonc pour former le câble aérien.

Selon une variante de réalisation de ce mode de réalisation, l'étape de contrôle discriminant peut être réalisée comme suit :
- préparation de l'assemblage composite multi-matériaux par mise à nu d'une de ses extrémités, cette dernière constituant la première électrode qui est mise à la terre, tandis que la couche externe constitue la deuxième électrode ;
- contrôle discriminant en tant que tel par génération d'un courant entre les première et deuxième électrodes en appliquant la tension seuil U_{S}.

De préférence, le procédé selon cette variante de réalisation pourra en outre comprendre une étape supplémentaire de détection en réflectométrie électrique, pour détecter et localiser un défaut dans l'assemblage composite multi-matériaux, cette étape supplémentaire de détection en réflectométrie électrique étant réalisée soit après l'étape de contrôle discriminant, soit au cours de cette étape de contrôle discriminant par génération d'un courant entre les première et deuxième électrodes en couplant la technologie de tension de claquage à la technologie de réflectométrie électrique.

La réflectométrie diélectrique permettant de quantifier le temps de propagation du signal électrique entre la source d'émission et/ou réception du signal électrique et le point de claquage dans l'une au moins des deux électrodes. Le temps de propagation, associé à la vitesse de propagation du signal dans le matériau d'au moins l'une des deux électrodes, permettent de définir un positionnement précis de claquage de la couche isolante du matériau composite.

### Brève description des figures

D'autres avantages et particularités de la présente invention résulteront de la description qui va suivre, donnée à titre d'exemple non limitatif et faite en référence aux figures annexées et aux exemples servant à illustrer les performances mécaniques des dispositifs de renforcement conformes à la présente invention :
- [fig. 1] : la figure 1 est une représentation schématique en coupe d'une installation mettant en œuvre le procédé selon l'invention dans le cas d'un assemblage composite multi-matériaux consistant en un élément de renforcement composite de forme tubulaire qui est constitué d'une couche interne à base de fibres de carbone et d'une deuxième couche à base de fibres de verre (ou jonc) ;
- [fig. 2] : la figure 2 est une représentation schématique en coupe d'une installation mettant en œuvre le procédé selon l'invention dans le cas d'un câble aérien consistant en un assemblage composite multi-matériaux comprenant, outre l'élément de renforcement composite de forme tubulaire identique à celui représenté sur la figure 1, une couche externe en aluminium toronné ;

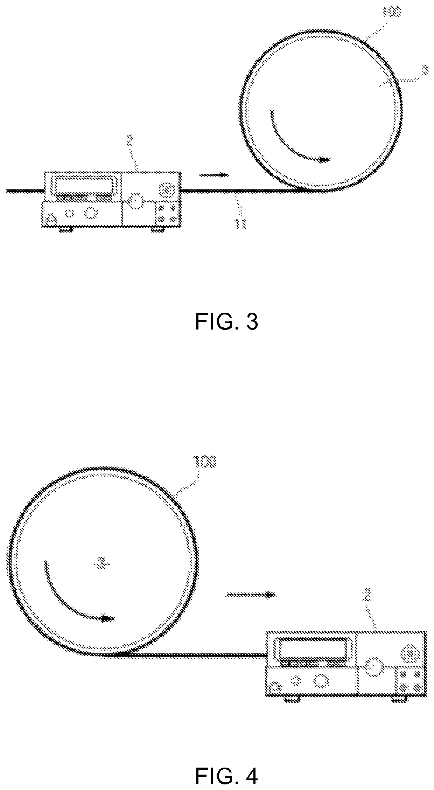

- [fig. 3] : la figure 3 est une représentation schématique en coupe d'une installation mettant en œuvre le procédé selon l'invention sur la ligne de production de l'assemblage composite multi-matériaux tel que représenté selon la figure 1 (jonc), après les étapes de superposition et cuisson de la couche interne et de la deuxième couche de l'élément de renforcement composite de forme tubulaire et préalablement à son enroulement sur un touret ;
- [fig. 4] : la figure 4 est une représentation schématique en coupe d'une installation mettant en œuvre le procédé selon l'invention lors du déroulement du jonc tel que représenté sur les figures 1 et 3 enroulé sur le dispositif de mise en rotation ;
- [fig. 5] : la figure 5 est une représentation schématique d'un puits de chute vertical (banc de choc dynamique) pour réaliser des tests d'impact sur des éléments de renforcement composites tels que représentés sur la figure 1 : l'homme du métier comprendra, à la lecture de la figure 5, que n'importe quel banc d'impact permettrait d'obtenir le même résultat ;
- [fig. 6] : la figure 6 comprend différentes coupes obtenues par tomographie à rayons X d'un élément de renforcement composite tel que représenté sur la figure 1, lorsque ce dernier présente un défaut ;

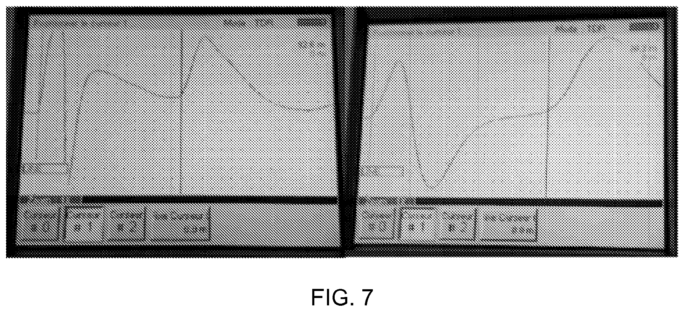

- [fig. 7] : la figure 7 comprend deux photographies montrant l'analyse de réflectométrie électrique sur des éléments de renforcement composites de forme tubulaire tels que représentés sur la figure 1 lors de tests de réflectométrie : sur la photographie de gauche, l'élément de renforcement est exempt de défaut, tandis que sur la photographie de droite, l'élément de renforcement présente un défaut structurel au niveau de la deuxième couche à base de fibres de verre.

Dans la description qui va suivre, des éléments identiques, similaires ou analogues seront désignés par les mêmes chiffres de référence.

Les figures 1 à 4 sont décrites plus en détail dans la description détaillée des figures, tandis que les figures 5 à 7 seront commentées plus en détail au niveau des exemples qui suivent, qui illustrent l'invention sans en limiter la portée.

### Description détaillée des figures

La figure 1 montre schématiquement une installation mettant en œuvre le procédé selon l'invention dans le cas d'un assemblage composite multi-matériaux 1 constitué d'un élément de renforcement composite de forme tubulaire 100 (ou jonc 100) qui est constitué d'une couche interne 10 à base de fibres de carbone et d'une deuxième couche 11 à base de fibres de verre. Cet élément de renforcement composite 100 est obtenu par des étapes de superposition et cuisson de la couche interne 10 et de la deuxième couche : la couche interne 10 est préalablement obtenue par pultrusion à partir d'un faisceau de fibres de carbone et d'une matrice polymérique imprégnant les fibres de carbone et les liant entre elles, et la deuxième couche 11 est obtenue lors de la même opération de pultrusion à partir d'un faisceau de fibres verre et de la même matrice polymérique qui imprègne également les fibres de verre en les liant entre elles.

La figure 1 montre en particulier qu'une partie 101 de la couche interne 10 est mise à nu, par exemple par polissage de la deuxième couche jusqu'à atteindre la couche interne 10 à base de fibres de carbone. Cette partie 101 de l'élément de renforcement composite de forme tubulaire 100 met à nu la couche interne constituant une première électrode. Une deuxième électrode 103 est ensuite disposée à la surface de l'élément de renforcement composite de forme tubulaire 100, sur la deuxième couche 11 à base de fibres de verre, par exemple à l'aide d'une bague métallique (notamment en aluminium) encerclant la couche 11 en verre. Un appareillage tel qu'un contrôleur d'isolement 2 est ensuite branché à chacune des électrodes 101, 103 (dont l'une des deux au moins est mise à la terre), puis mis sous tension jusqu'à une tension seuil U_{S}, qui est préalablement définie par calibration pour être caractéristique d'une absence de défaut structurel (cf. exemple 1 détaillant comment est réalisée cette calibration). La détection d'un claquage signifie l'existence d'un défaut structurel 3 dans la deuxième couche à base de fibres verre 11. Dans ce cas, l'assemblage composite multi-matériaux 1 doit être jugé non conforme et écarté.

La figure 2 montre schématiquement la même installation que celle illustrée sur la figure 1, mettant en œuvre le procédé selon l'invention dans le cas d'un assemblage composite multi-matériaux 1 comprenant, outre l'élément de renforcement composite de forme tubulaire 100 de la figure 1, deux couches externes 4 en aluminium toronné recouvrant partiellement l'élément de renforcement 100 et formant ainsi un câble électrique aérien. La deuxième couche 11 à base de fibres de verre imprégnées d'une matrice polymérique constitue un isolant électrique entre la couche externe 4 en aluminium et la couche interne 10 à base de fibres de carbone imprégnées de la même matrice polymérique, empêchant ainsi toute forme de corrosion galvanique de l'une des couches par l'autre.

Le procédé selon l'invention utilise les propriétés d'isolant électrique de la couche interne 11 et les propriétés de conduction électrique de la couche externe 4 pour détecter et caractériser, le cas échéant, la présence d'un défaut structurel dans l'assemblage composite multi-matériaux 1 constituant le câble aérien.

Dans ce cas particulier, lorsqu'il y a un claquage, la localisation du défaut dans l'assemblage composite multi-matériaux 1 formant le câble est plus complexe que dans les cas de simples joncs 100 (illustrés sur les figures 1, 3 ou 4) du fait de la grande surface sous tension : l'ensemble de la portion de câble 1 est concerné et met face à face les deux électrodes 101, 103. Un claquage est donc impossible à localiser avec précision, une méthode complémentaire de localisation du défaut par réflectométrie est donc conseillée, comme illustré à l'exemple 3.

La figure 3 montre une installation mettant en œuvre le procédé selon l'invention sur la ligne de production de l'assemblage composite multi-matériaux tel que représenté selon la figure 1, c'est à dire consistant uniquement en l'élément de renforcement composite de forme tubulaire 100 (ou jonc), préalablement à son enroulement sur un dispositif de mise en rotation tel qu'un touret 3. Dans ce cas, le procédé de contrôle discriminant se déroule alors comme suit :
- de même que pour les installations de mise en œuvre du procédé selon l'invention illustrées sur les figures 1 et 2, le jonc 100 est préparé à son extrémité 101, par usinage de la deuxième couche 11 jusqu'à atteindre la couche interne 10 à base de fibres de carbone ;
- cette extrémité 101 du jonc 100 est alors insérée dans le contrôleur d'isolement 2, puis arrimée sur le touret 3 dans l'emplacement prévu à cet effet : elle constitue la première électrode 101, qui est mise à la terre ;
- on applique une deuxième électrode 103 à la surface du jonc 100 sur la deuxième couche 11 du jonc 100 ;
- le contrôleur d'isolement 2 est ensuite branché à chacune des électrodes 101, 103 ;
- une fois que la rotation du touret 3 démarre, le contrôle discriminant du jonc 100 est lancé : on met sous tension le contrôleur d'isolement 2 et la tension augmente jusqu'à la tension seuil U_{S} (comprise entre 5 kV et 40 kV, et préférentiellement entre 8 kV et 20 kV, comme illustré dans les exemples ci-après) qui est préalablement définie par calibration pour être caractéristique d'une absence de défaut structurel (sauf si un claquage est observé avant d'atteindre cette tension en raison de la présence effective d'un défaut structurel dans le jonc 100) ;
- un opérateur de production observe les résultats du contrôle discriminant sur un écran de contrôle en temps réel et peut décider d'intervenir lorsqu'un claquage est observé (caractérisant un défaut présent dans la deuxième couche 11 à base de fibres de verre) : cette intervention peut consister soit en un arrêt complet de la ligne de l'installation, soit en une réparation locale du jonc 100 sans interruption de l'installation.

La figure 4 montre une installation mettant en œuvre le procédé selon l'invention sur la ligne de production du câble aérien constitué de l'assemblage composite multi-matériaux tel que représenté selon la figure 2, c'est à dire consistant uniquement en l'élément de renforcement composite de forme tubulaire 100 (ou jonc 100) avant l'étape de toronnage de l'aluminium, lors du déroulement du jonc 100 enroulé sur le dispositif de mise en rotation. Dans ce cas, le procédé de contrôle discriminant se déroule alors comme suit :
- de même que pour les installations de mise en œuvre du procédé selon l'invention illustrées sur les figures 1 et 2, le jonc 100 est préparé à son extrémité 101 (par usinage de la deuxième couche 11 jusqu'à atteindre la couche interne 10 à base de fibres de carbone ;
- cette extrémité 101 du jonc 100 est alors insérée dans le contrôleur d'isolement 2, puis arrimée sur le touret 3 dans l'emplacement prévu à cet effet : elle constitue la première électrode 101, qui est mise à la terre ;
- on applique une deuxième électrode 103 à la surface du jonc 100 sur la deuxième couche 11 du jonc 100 ;
- le contrôleur d'isolement 2 est ensuite branché à chacune des électrodes 101, 103 ;
- une fois que la rotation du touret 3 démarre, le contrôle discriminant du jonc 100 est lancé : on met sous tension le contrôleur d'isolement 2 et la tension augmente jusqu'à la tension seuil U_{S} (comprise entre 5 kV et 40 kV, et préférentiellement entre 8 kV et 20 kV, comme illustré dans les exemples ci-après) qui est préalablement définie par calibration pour être caractéristique d'une absence de défaut structurel (sauf si un claquage est observé avant d'atteindre cette tension en raison de la présence effective d'un défaut structurel dans le jonc 100) ;
- un opérateur de production observe les résultats du contrôle discriminant sur l'écran de contrôle en temps réel et peut décider d'intervenir lorsqu'un claquage est observé (caractérisant un défaut présent dans la deuxième couche 11 à base de fibres de verre) : cette intervention peut consister soit en un arrêt de l'installation, soit en une réparation locale du jonc 100 sans interruption de la ligne de production.

### EXEMPLES

### EXEMPLE 1 : calibration du procédé de contrôle discriminant selon l'invention à l'aide de l'installation représentée sur la figure 1

En vue de pouvoir réaliser le contrôle discriminant d'un assemblage composite multi-matériaux comportant une couche interne électriquement conductrice et une deuxième couche isolante électrique et, le cas échéant, de détecter un éventuel défaut structurel dans la deuxième couche et de le caractériser, il convient préalablement de réaliser une calibration afin de définir la valeur de la tension seuil Us, caractéristique de l'absence de tout défaut structurel dans la deuxième couche. Cette calibration est réalisée sur l'installation illustrée sur la figure 1, dans laquelle on utilise à titre de contrôleur d'isolement 2 le dispositif commercialisé par la société RS Pro sous la dénomination commerciale ITT-2010.

On teste, sur cette installation, les échantillons suivants :
10 joncs 100 sains (c'est à dire ne présentant aucun défaut structurel critique), de longueur 6 m ±20 cm, et
une pluralité de joncs 100 comportant des défauts critiques connus, de longueur identique à celle des joncs sains, comprenant :
   10 joncs 100 présentant un défaut d'imprégnation par la matrice polymérique des différentes fibres (de carbone et/ou de verre) dans la couche interne 10 et/ou la deuxième couche),
   10 joncs 100 présentant des bourrages de carbone, ce qui a pour effet de rompre localement l'alignement et l'intégrité de ces joncs 100,
   10 joncs vieillis en environnement humide (par exemple des échantillons ayant passé au moins 24 heures en immersion dans de l'eau à 90°C),
   10 joncs 100 ayant été soumis à différents impacts dans un banc de choc dynamique vertical 5 (ou tour d'impactage) tel que représenté sur la figure 5, qui permet de réaliser des chocs linéaires à énergie réglable (on teste différents niveaux d'énergie : entre 3 joules et 6 Joules), et enfin 10 joncs 100 dont la deuxième couche 11 à base de fibres de verre a été réduite de plusieurs dixièmes.

Sur la base de ces assemblages connus, on réalise une calibration du procédé de contrôle discriminant selon l'invention décrit ci-dessus, en notant la valeur de la tension de claquage (comme illustré à l'exemple 1 et sur la figure 5) pour chaque jonc présentant un défaut structurel critique donné et pour chaque jonc sain. Les résultats de ces essais sont rassemblés dans le tableau 1 ci-après :

**[Table 1]**

| Echantillons | Tension moyenne mesurée (en V) juste avant claquage |
|---|---|
| Joncs ayant été soumis à un vieillissement humide | Pas de claquage observé |
| (24 h en immersion dans de l'eau à 90°C) | |
| Joncs impacté à 4 Joules | Claquage observé à partir de 4842 V |
| Joncs impacté à 5 Joules | Claquage observé à partir de 4624 V |
| Joncs impacté à 6 Joules | Claquage observé à partir de 2415 V |
| Jonc avec une épaisseur d'isolation en composite à renfort fibre de verre de 0.4 mm d'épaisseur | Pas de claquage observé |
| Jonc avec une épaisseur d'isolation en composite à renfort fibre de verre de 0.3 mm d'épaisseur | Pas de claquage observé |
| Jonc avec une épaisseur d'isolation en composite à renfort fibre de verre de 0.2mm d'épaisseur | Pas de claquage observé |
| Jonc avec une épaisseur d'isolation en composite à renfort fibre de verre de 0.1mm d'épaisseur | Pas de claquage observé |
| Joncs sains (de longueur 1,6 m) | Pas de claquage observé |

Ces essais de calibration montrent que les joncs présentant des défauts majeurs claquent à des niveaux de tension inférieur à 6000 V.

### EXEMPLE 2 : Précalibration en ligne du procédé de contrôle discriminant selon l'invention à l'aide de l'installation représentée sur la figure 3

On réalise une précalibration en vue du contrôle en ligne d'un jonc conformément au procédé selon l'invention tel qu'illustré sur la figure 3 et commenté dans la partie descriptive correspondante. Cette calibration est réalisée sur l'installation illustrée sur la figure 3, dans laquelle on utilise à titre de contrôleur d'isolement 2, le dispositif commercialisé par la société Zumba Electronic AG sous la dénomination DST28A.

Les échantillons testés sont similaires à ceux de l'exemple 1, mais se présente de manière similaire à la calibration réalisée dans l'exemple 1. On applique une tension avec une rampe allant de 0 à 28 kV et on mesure la tension de claquage pour différents types de joncs avec défaut et différents joncs sains. Les résultats sont rassemblés dans le tableau 2 ci-après :

**[Table 2]**

| Essais en ligne réalisés sur différents types de joncs | tension moyenne mesurée (en V) juste avant le claquage | Commentaires |
|---|---|---|
| Joncs ayant été soumis à un vieillissement humide | 14000 | 7 essais réalisés et 7 claquages observés |
| Joncs impacté à 3 Joules | 7000 | |
| Joncs impacté à 4 Joules | 6000 | |
| Joncs impacté à 5 Joules | 7000 | |
| Joncs impacté à 6 Joules | 5500 | |
| Joncs avec des fibres sèches (défauts d'imprégnation) | 8000 | |
| Joncs présentant des bourrages de carbone | 3000 | |
| Joncs sains | 21000 | 3 essais réalisés |

Ces essais de calibration montrent que les joncs présentant des défauts qui claquent également à des niveaux de tension compris entre 2000 V et 8000 V, tandis que les joncs sains claquent au-dessus de 20000V. Ainsi, pour chaque assemblage composite multi-matériaux de caractéristiques données, le contrôle discriminant selon le procédé selon l'invention pourra être réalisé en appliquant la tension seuil U_{S} à l'issue de laquelle une valeur de tension seuil U_{S} est obtenue, celle-ci se situant donc dans une gamme comprise entre 8000V et 20000V.

### EXEMPLE 3 : Essais de réflectométrie

Dans le cas particulier d'un assemblage composite de type câble aérien (tel qu'illustré sur la figure 2, comportant notamment un jonc et au moins une couche externe en aluminium), lorsqu'il y a un claquage, la localisation du défaut dans l'assemblage composite multi-matériaux 1 formant le câble est plus complexe que dans les cas de simples joncs 100 (illustrés sur les figures 1, 3 ou 4) du fait de la grande surface des deux électrodes qui parcourt la quasi-totalité de la longueur de câble de plusieurs centaines de mètres, comme indiqué précédemment. Un claquage étant impossible à localiser avec précision, il est conseiller de réaliser en complément du procédé selon l'invention, des tests de localisation du défaut par réflectométrie électrique.

Lors de tests de réflectométrie, le signal électrique doit être porté par deux conducteurs. Toute discontinuité dans le produit analysé crée une réflexion dans le système, qui peut être localisée en observant son délai émission-réception. Comme pour la tension de claquage, les tests de réflectométrie électrique reposent sur un principe physique de mesure de vitesse et temps de propagation du signal électrique dans un matériaux donné.

Les essais présentés dans le présent exemple ont pour but de tester la faisabilité des tests de réflectométrie, en opérant sur des échantillons spécifiques d'assemblages composites, constitués de joncs 100 similaires à ceux illustrés sur la figure 1, à la surface desquels 4 fils de cuivre (par jonc 100) sont insérés (jouant ainsi le rôle de la couche externe 4). La longueur de ces échantillons (jonc + fils de cuivre) est de 90 m. Le carbone de la couche interne des joncs 100 et le cuivre en la couche externe 4 servent donc de conducteur au signal électrique pour la réflectométrie.

Une fois formés les échantillons (assemblages de jonc et de fils de cuivre à la surface), les extrémités des fils de cuivre sont extraites de l'assemblage.

Pour ces essais, les tests de réflectométrie sont réalisés à l'aide d'un appareillage de réflectométrie temporelle EDTR (acronyme en langue anglaise pour « *Electrical Time Domain Reflectometry* »)*.* La vitesse d'onde électrique est d'abord étalonnée entre 2 fils de cuivre en renseignant dans l'appareillage la vitesse de propagation de l'onde dans le matériau sans défaut de forme ou de continuité (à gauche de la figure 7, où la seule discontinuité du signal observée sur l'écran par l'opérateur est à la sortie à environ 92,6 m). Il a ensuite été possible de retrouver avec succès la même longueur sur la mesure entre les autres fils, et entre le cœur carbone et un fil de cuivre, démontrant sur ce point la faisabilité par détection en réflectométrie électrique entre un conducteur métallique et l'âme carbone de notre produit. Enfin, un fil de cuivre à 30 m a été volontairement rompu, simulant un défaut de l'un des deux conducteurs constituant le câble : la position du défaut a pu être renseignée par l'EDTR (à droite de la figure 7, à 30,2 m) avec précision sur l'appareil de réflectométrie qui identifie une variation importante de la vitesse de propagation de l'onde au niveau de la discontinuité électrique généré dans le matériau conducteur.

Le test s'est donc avéré probant, et donne une localisation de défaut précise, comme illustré par la figure 7. Les photographies de la figure 7, qui indiquent la position linéaire du défaut.

Cette méthode a donc tout son intérêt dans le cas de l'analyse d'un câble sur site installation, où les deux électrodes (âme carbone et aluminium toronné) se font face sur plusieurs centaines et/ou milliers de mètres : lors d'un contrôle de la qualité d'un câble aérien, un signal claqué peut être observé par un réflectomètre adapté et permettre en retour de localiser la position du défaut dans le jonc.

### EXEMPLE 4 : analyse par tomographie

Des analyses par tomographie ont été réalisées sur un jonc 100 présentant un défaut et pour lequel un claquage a été observé lors de la calibration du contrôle discriminant réalisé à l'exemple 1. La figure 6 montre différentes coupes prises sur ce jonc, à différents niveaux de la zone analysée (zone centrale de la photographie de droite). La fine ligne noire sensiblement verticale que l'on observe à la surface de la zone centrale analysée de l'échantillon correspond au chemin de propagation de l'arc électrique du claquage. Sur les coupes transversales 1 à 4 (photographies de gauche sur la figure 5), cela se manifeste par un défaut présent dans la deuxième couche 11 du jonc testé (de couleur blanche et entouré d'une ellipse sur chacune des photographies de coupe).

Cette analyse tomographie d'un jonc avec défaut montre clairement que lorsqu'un assemblage composite, par exemple sous forme d'un jonc 100 dans le cas présent, présente un défaut qui se propage dans l'assemblage, le procédé de contrôle discriminant selon l'invention le détecte.

### LISTE DES REFERENCES

1 - Ali Abedini-Livari, Mahdi Eshaghi-Maskouni, Mehdi Vakilian, Keyvan Firuzi. " Line Composite Insulators Condition Monitoring through Partial Discharge Measurement"; The 34th International Power System Conference (PSC2019) 9-11 December, Niroo Research Institute, Tehran, Iran.
2 - Enis Tuncer, sidor Sauers, D. Randy James, and Alvin R. Ellis. "Electrical Insulation Characteristics of Glass Fiber Reinforced Resins" ; IEEE TRANSACTIONS ON APPLIED SUPERCONDUCTIVITY, VOL. 19, NO. 3, JUNE 2009.
3 - Sraren Find Madsen, J. Holboell, M. Henriksen, Flemming Mraller Larsen, Lars Bo Hansen, Kim Bertelsen. " Breakdown tests of Glass Fibre Reinforced Polymers (GFRP) as part of Improved Lightning Protection of Wind Turbine Blades"; Conference Record of the 2004 IEEE Intemational Symposium on Electrical Insulation, Indianapolis, IN USA, 19-22 September 2004.
4 - S.F. Madsen, J. Holboll and M. Henriksen Ørsted. " Direct relationship between breakdown strengthand tracking index of composites»; Conference Record of the 2006 IEEE International Symposium on Electrical Insulation.

## Revendications

1. Procédé de contrôle discriminant d'un assemblage composite multi-matériaux (1) comprenant au moins une couche interne (10) en un premier matériau composite conducteur de l'électricité et une deuxième couche (11) en un deuxième matériau composite électriquement isolant, ladite deuxième couche (11) recouvrant ladite première couche interne (10), ledit procédé étant **caractérisé en ce qu'**il comprend les étapes suivantes :
- préparation dudit assemblage composite multi-matériaux (1) par mise à nu d'une partie (101) de ladite couche interne (10), ladite partie (101) constituant une première électrode ;
- application d'une deuxième électrode (103) à la surface de ladite deuxième couche (11), l'une des première (101) et deuxième électrodes (103) étant mise à la terre ;
- contrôle discriminant par génération d'un courant entre les première (101) et deuxième électrodes (103) en appliquant une tension seuil U_{S} préalablement définie par calibration sur des assemblages (1) dont une partie est sans défaut et une autre partie comporte des défauts structurels connus pour être caractéristique d'une absence de défaut structurel, l'apparition d'un claquage à une tension inférieure à ladite tension seuil U_{S} étant révélateur de la présence d'au moins un défaut structurel dans ladite au moins une couche interne (10) s'étant propagé dans la deuxième couche (11) dudit assemblage composite (1).

2. Procédé selon la revendication 1, selon lequel, dans l'assemblage composite multi-matériaux (1), le premier matériau conducteur de l'électricité comprend des fibres de carbone.

3. Procédé selon l'une quelconque des revendications 1 et 2, selon lequel, dans l'assemblage composite multi-matériaux (1), un deuxième matériau électriquement isolant comprend des fibres de verre.

4. Procédé selon les revendications 2 et 3 prises conjointement, selon lequel ledit assemblage composite multi-matériaux (1) comprend un élément de renforcement composite de forme tubulaire (100) destiné à être utilisé dans un câble électrique aérien, ledit assemblage composite multi-matériaux (1) étant obtenu par des étapes de superposition et de cuisson simultanées de ladite couche interne (10) et de ladite deuxième couche (11), ladite couche interne (10) étant obtenue par pultrusion à partir d'un faisceau de fibres de carbone et d'une matrice polymérique imprégnant lesdites fibres de carbone et les liant entre elles, et ladite deuxième couche (11) étant obtenue lors de la même opération de pultrusion à partir d'un faisceau de fibres de verre et de ladite matrice polymérique imprégnant lesdites fibres de verre et les liant entre elles.

5. Procédé selon la revendication 4, selon lequel l'étape de contrôle discriminant dudit assemblage composite multi-matériaux (1) est réalisée sur la ligne de production dudit élément de renforcement composite de forme tubulaire (100) après les étapes de superposition et cuisson de ladite couche interne (10) et de ladite deuxième couche (11) dudit élément de renforcement composite de forme tubulaire (100) et préalablement à une étape d'enroulement sur un dispositif de mise en rotation (3) dudit élément de renforcement composite de forme tubulaire (100) ainsi obtenu, ledit procédé comprenant les étapes suivantes :
- préparation de l'une des extrémités (101) dudit élément de renforcement composite de forme tubulaire (100) par arrimage audit dispositif de mise en rotation (3), puis par mise à nu de ladite couche interne (10) au niveau de ladite extrémité (101), ladite extrémité (101) constituant la première électrode qui est mise à la terre ;
- application d'une deuxième électrode (103) à la surface de ladite deuxième couche (11) ;
- mise en rotation dudit dispositif de mise en rotation (3) pour enrouler ledit élément de renforcement composite de forme tubulaire (100) ;
- contrôle discriminant par génération d'un courant entre les première (101) et deuxième électrodes (103) en appliquant la tension seuil U_{S}.

6. Procédé selon la revendication 4, selon lequel l'étape de contrôle discriminant est réalisée lors du déroulement dudit élément de renforcement composite de forme tubulaire (100) enroulé sur ledit dispositif de mise en rotation (3), ledit procédé comprenant les étapes de :
- préparation de l'une des extrémités (101) dudit élément de renforcement composite de forme tubulaire (100) enroulé sur ledit dispositif de mise en rotation (3) par mise à nu de ladite couche interne (10) au niveau de l'extrémité (101), ladite extrémité (101) constituant la première électrode (101) qui est mise à la terre ;
- application d'une deuxième électrode (103) à la surface de ladite deuxième couche (11) ;
- déroulement dudit élément de renforcement composite de forme tubulaire (1) ;
- contrôle discriminant par génération d'un courant entre les première (101) et deuxième électrodes (103) en appliquant la tension seuil U_{S}.

7. Procédé selon la revendication 4, selon lequel ledit assemblage composite multi-matériaux (1) comprend, outre ledit élément de renforcement composite de forme tubulaire (100), au moins une couche externe (4) recouvrant au moins partiellement ladite deuxième couche (11), ladite couche externe (4) étant en matériau conducteur de l'électricité, de préférence métallique, et mieux en aluminium toronné.

8. Procédé selon la revendication 7, selon lequel l'étape de contrôle discriminant comprend les étapes suivantes :
- préparation dudit assemblage composite multi-matériaux (1) par mise à nu d'une extrémité (101) dudit assemblage composite multi-matériaux (1), ladite extrémité (101) constituant la première électrode qui est mise à la terre et la couche externe (4) constituant la deuxième électrode (103) ;
- contrôle discriminant par génération d'un courant entre les première (101) et deuxième électrodes (103) en appliquant la tension seuil U_{S}.

9. Procédé selon la revendication 8, comprenant en outre une étape supplémentaire de détection en réflectométrie électrique pour détecter et localiser un défaut dans ledit assemblage composite multi-matériaux (1), ladite étape supplémentaire de détection en réflectométrie électrique étant réalisée soit après l'étape de contrôle discriminant, soit au cours de ladite étape de contrôle discriminant par génération d'un courant entre les première (101) et deuxième électrodes (103) en couplant la technologie de tension de claquage à la technologie de réflectométrie électrique.

## Patentansprüche

1. Verfahren zur diskriminierenden Prüfung einer Mehrmaterial-Verbundanordnung (1), die mindestens eine innere Schicht (10) aus einem ersten elektrisch leitfähigen Verbundwerkstoff und eine zweite Schicht (11) aus einem zweiten elektrisch isolierenden Verbundwerkstoff umfasst, wobei die genannte zweite Schicht (11) die genannte erste innere Schicht (10) bedeckt, wobei das genannte Verfahren **dadurch gekennzeichnet ist, dass** es die folgenden Schritte umfasst:
- Vorbereiten der genannten Mehrmaterial-Verbundanordnung (1) durch Freilegen eines Teils (101) der genannten inneren Schicht (10), wobei der genannte Teil (101) eine erste Elektrode bildet;
- Anbringen einer zweiten Elektrode (103) an der Oberfläche der genannten zweiten Schicht (11), wobei eine der ersten (101) und der zweiten Elektrode (103) geerdet ist;
- diskriminierende Prüfung durch Erzeugen eines Stroms zwischen der ersten (101) und der zweiten Elektrode (103) unter Anlegen einer Schwellenspannung Uₛ, die zuvor durch Kalibrierung an Anordnungen (1) festgelegt wird, von denen ein Teil fehlerfrei ist und ein anderer Teil bekannte strukturelle Fehler aufweist, um für eine Abwesenheit eines strukturellen Fehlers charakteristisch zu sein, wobei das Auftreten eines Durchschlags bei einer Spannung, die niedriger als die genannte Schwellenspannung Uₛ ist, das Vorhandensein mindestens eines strukturellen Fehlers in der genannten mindestens einen inneren Schicht (10) anzeigt, der sich in die zweite Schicht (11) der genannten Verbundanordnung (1) ausgebreitet hat.

2. Verfahren nach Anspruch 1, bei dem in der Mehrmaterial-Verbundanordnung (1) der erste elektrisch leitfähige Werkstoff Kohlenstofffasern umfasst.

3. Verfahren nach einem der Ansprüche 1 und 2, bei dem in der Mehrmaterial-Verbundanordnung (1) ein zweiter elektrisch isolierender Werkstoff Glasfasern umfasst.

4. Verfahren nach den Ansprüchen 2 und 3 in Kombination, bei dem die genannte Mehrmaterial-Verbundanordnung (1) ein rohrförmiges Verbundverstärkungselement (100) umfasst, das dazu bestimmt ist, in einem elektrischen Freileitungskabel verwendet zu werden, wobei die genannte Mehrmaterial-Verbundanordnung (1) durch Schritte des gleichzeitigen Übereinanderlegens und Aushärtens der genannten inneren Schicht (10) und der genannten zweiten Schicht (11) erhalten wird, wobei die genannte innere Schicht (10) durch Pultrusion aus einem Bündel von Kohlenstofffasern und einer Polymermatrix, die die genannten Kohlenstofffasern imprägniert und sie miteinander verbindet, erhalten wird, und die genannte zweite Schicht (11) bei demselben Pultrusionsvorgang aus einem Bündel von Glasfasern und aus der genannten Polymermatrix, die die genannten Glasfasern imprägniert und sie miteinander verbindet, erhalten wird.

5. Verfahren nach Anspruch 4, bei dem der Schritt der diskriminierenden Prüfung der genannten Mehrmaterial-Verbundanordnung (1) auf der Produktionslinie des genannten rohrförmigen Verbundverstärkungselements (100) nach den Schritten des Übereinanderlegens und Aushärtens der genannten inneren Schicht (10) und der genannten zweiten Schicht (11) des genannten rohrförmigen Verbundverstärkungselements (100) und vor einem Schritt des Aufwickelns des so erhaltenen rohrförmigen Verbundverstärkungselements (100) auf eine Drehvorrichtung (3) durchgeführt wird, wobei das genannte Verfahren die folgenden Schritte umfasst:
- Vorbereiten eines der Enden (101) des genannten rohrförmigen Verbundverstärkungselements (100) durch Befestigen an der genannten Drehvorrichtung (3), dann durch Freilegen der genannten inneren Schicht (10) am genannten Ende (101), wobei das genannte Ende (101) die erste Elektrode bildet, die geerdet ist;
- Anbringen einer zweiten Elektrode (103) an der Oberfläche der genannten zweiten Schicht (11);
- Versetzen der genannten Drehvorrichtung (3) in Drehung, um das genannte rohrförmige Verbundverstärkungselement (100) aufzuwickeln;
- diskriminierende Prüfung durch Erzeugen eines Stroms zwischen der ersten (101) und der zweiten Elektrode (103) unter Anlegen der Schwellenspannung Uₛ.

6. Verfahren nach Anspruch 4, bei dem der Schritt der diskriminierenden Prüfung während des Abwickelns des genannten rohrförmigen Verbundverstärkungselements (100), das auf die genannte Drehvorrichtung (3) aufgewickelt ist, durchgeführt wird, wobei das genannte Verfahren die Schritte umfasst:
- Vorbereiten eines der Enden (101) des genannten rohrförmigen Verbundverstärkungselements (100), das auf die genannte Drehvorrichtung (3) aufgewickelt ist, durch Freilegen der genannten inneren Schicht (10) am Ende (101), wobei das genannte Ende (101) die erste Elektrode (101) bildet, die geerdet ist;
- Anbringen einer zweiten Elektrode (103) an der Oberfläche der genannten zweiten Schicht (11);
- Abwickeln des genannten rohrförmigen Verbundverstärkungselements (1);
- diskriminierende Prüfung durch Erzeugen eines Stroms zwischen der ersten (101) und der zweiten Elektrode (103) unter Anlegen der Schwellenspannung Uₛ.

7. Verfahren nach Anspruch 4, bei dem die genannte Mehrmaterial-Verbundanordnung (1) außer dem genannten rohrförmigen Verbundverstärkungselement (100) mindestens eine äußere Schicht (4) umfasst, die die genannte zweite Schicht (11) zumindest teilweise bedeckt, wobei die genannte äußere Schicht (4) aus einem elektrisch leitfähigen Werkstoff, vorzugsweise metallisch, und besser aus verseiltem Aluminium besteht.

8. Verfahren nach Anspruch 7, bei dem der Schritt der diskriminierenden Prüfung die folgenden Schritte umfasst:
- Vorbereiten der genannten Mehrmaterial-Verbundanordnung (1) durch Freilegen eines Endes (101) der genannten Mehrmaterial-Verbundanordnung (1), wobei das genannte Ende (101) die erste Elektrode bildet, die geerdet ist, und die äußere Schicht (4) die zweite Elektrode (103) bildet;
- diskriminierende Prüfung durch Erzeugen eines Stroms zwischen der ersten (101) und der zweiten Elektrode (103) unter Anlegen der Schwellenspannung Uₛ.

9. Verfahren nach Anspruch 8, ferner umfassend einen zusätzlichen Schritt der Erfassung durch elektrische Reflektometrie, um einen Fehler in der genannten Mehrmaterial-Verbundanordnung (1) zu erfassen und zu lokalisieren, wobei der genannte zusätzliche Schritt der Erfassung durch elektrische Reflektometrie entweder nach dem Schritt der diskriminierenden Prüfung oder während des genannten Schritts der diskriminierenden Prüfung durch Erzeugen eines Stroms zwischen der ersten (101) und der zweiten Elektrode (103) durchgeführt wird, indem die Durchschlagsspannungstechnologie mit der elektrischen Reflektometrietechnologie gekoppelt wird.

## Claims

1. Method for the discriminating inspection of a multi-material composite assembly (1) comprising at least one inner layer (10) made of a first electrically conductive composite material and a second layer (11) made of a second electrically insulating composite material, said second layer (11) covering said first inner layer (10), said method being **characterized in that** it comprises the following steps:
- preparing said multi-material composite assembly (1) by exposing a part (101) of said inner layer (10), said part (101) constituting a first electrode;
- applying a second electrode (103) to the surface of said second layer (11), one of the first (101) and second electrodes (103) being earthed;
- discriminating inspection by generating a current between the first (101) and second electrodes (103) by applying a threshold voltage Uₛ previously defined by calibration on assemblies (1) of which one part is free of defects and another part comprises known structural defects so as to be characteristic of an absence of structural defect, the occurrence of a breakdown at a voltage lower than said threshold voltage Uₛ being indicative of the presence of at least one structural defect in said at least one inner layer (10) having propagated into the second layer (11) of said composite assembly (1).

2. Method according to Claim 1, wherein, in the multi-material composite assembly (1), the first electrically conductive material comprises carbon fibres.

3. Method according to either of Claims 1 and 2, wherein, in the multi-material composite assembly (1), a second electrically insulating material comprises glass fibres.

4. Method according to Claims 2 and 3 taken in combination, wherein said multi-material composite assembly (1) comprises a composite reinforcing element of tubular shape (100) intended to be used in an overhead electric cable, said multi-material composite assembly (1) being obtained by steps of simultaneous superposition and curing of said inner layer (10) and of said second layer (11), said inner layer (10) being obtained by pultrusion from a bundle of carbon fibres and a polymer matrix impregnating said carbon fibres and binding them together, and said second layer (11) being obtained during the same pultrusion operation from a bundle of glass fibres and from said polymer matrix impregnating said glass fibres and binding them together.

5. Method according to Claim 4, wherein the step of discriminating inspection of said multi-material composite assembly (1) is carried out on the production line of said composite reinforcing element of tubular shape (100) after the steps of superposition and curing of said inner layer (10) and of said second layer (11) of said composite reinforcing element of tubular shape (100) and prior to a step of winding the thus obtained composite reinforcing element of tubular shape (100) onto a rotating device (3), said method comprising the following steps:
- preparing one of the ends (101) of said composite reinforcing element of tubular shape (100) by securing it to said rotating device (3), then by exposing said inner layer (10) at said end (101), said end (101) constituting the first electrode which is earthed;
- applying a second electrode (103) to the surface of said second layer (11);
- setting said rotating device (3) in rotation in order to wind said composite reinforcing element of tubular shape (100);
- discriminating inspection by generating a current between the first (101) and second electrodes (103) by applying the threshold voltage Uₛ.

6. Method according to Claim 4, wherein the step of discriminating inspection is carried out during the unwinding of said composite reinforcing element of tubular shape (100) wound onto said rotating device (3), said method comprising the steps of:
- preparing one of the ends (101) of said composite reinforcing element of tubular shape (100) wound onto said rotating device (3) by exposing said inner layer (10) at the end (101), said end (101) constituting the first electrode (101) which is earthed;
- applying a second electrode (103) to the surface of said second layer (11);
- unwinding said composite reinforcing element of tubular shape (1);
- discriminating inspection by generating a current between the first (101) and second electrodes (103) by applying the threshold voltage Uₛ.

7. Method according to Claim 4, wherein said multi-material composite assembly (1) comprises, in addition to said composite reinforcing element of tubular shape (100), at least one outer layer (4) at least partially covering said second layer (11), said outer layer (4) being made of an electrically conductive material, preferably metallic, and more preferably of stranded aluminium.

8. Method according to Claim 7, wherein the discriminating inspection step comprises the following steps:
- preparing said multi-material composite assembly (1) by exposing an end (101) of said multi-material composite assembly (1), said end (101) constituting the first electrode which is earthed and the outer layer (4) constituting the second electrode (103);
- discriminating inspection by generating a current between the first (101) and second electrodes (103) by applying the threshold voltage Uₛ.

9. Method according to Claim 8, further comprising an additional step of detection by electrical reflectometry for detecting and locating a defect in said multi-material composite assembly (1), said additional step of detection by electrical reflectometry being carried out either after the discriminating inspection step, or during said discriminating inspection step by generating a current between the first (101) and second electrodes (103) by coupling the breakdown voltage technology to the electrical reflectometry technology.
